Europäisches Patentamt

European Patent Office

Office européen des brevets

(19) 

(11) Numéro de publication: **0 083 265**
**B1**

## (12) FASCICULE DE BREVET EUROPEEN

(45) Date de publication du fascicule du brevet:
**11.09.85**

(51) Int. Cl.⁴: **H 01 L 23/48,** H 01 L 23/52

(21) Numéro de dépôt: **82402290.9**

(22) Date de dépôt: **14.12.82**

(54) **Support d'interconnexion d'un boîtier de circuit intégré sur un circuit imprimé, et système d'interconnexion utilisant un tel support.**

(30) Priorité: **22.12.81 FR 8123954**

(43) Date de publication de la demande:
**06.07.83 Bulletin 83/27**

(45) Mention de la délivrance du brevet:
**11.09.85 Bulletin 85/37**

(84) Etats contractants désignés:
**DE GB IT**

(56) Documents cités:
**FR - A - 2 332 620**
**US - A - 3 390 308**

**IBM TECHNICAL DISCLOSURE BULLETIN, vol. 23, no. 9, février 1981, pages 4062-4063, New York, USA S.M. JENSEN et al.: "Pin/chip carrier assembly"**
**IBM TECHNICAL DISCLOSURE BULLETIN, vol. 22, no. 10, mars 1980, pages 4464-4466, New York, USA D.G. PITTWOOD: "Chip attachment lead formation"**
**IBM TECHNICAL DISCLOSURE BULLETIN, vol. 22, no. 4, septembre 1979, pages 1428-1429, New York, USA H.D. STACKHOUSE: "Module package with heat sink between substrate and circuit board"**

(73) Titulaire: **SOCAPEX, 10 bis, quai Léon Blum, F-92153 Suresnes (FR)**

(72) Inventeur: **Bricaud, Hervé, THOMSON-CSF SCPI 173, bld Haussmann, F-75379 Paris Cedex 08 (FR)**
Inventeur: **Olive, Jean-Louis, THOMSON-CSF SCPI 173, bld Haussmann, F-75379 Paris Cedex 08 (FR)**

(74) Mandataire: **Ruellan-Lemonnier, Brigitte et al, THOMSON-CSF SCPI 173, boulevard Haussmann, F-75379 Paris Cedex 08 (FR)**

EP 0 083 265 B1

## Description

La présente invention concerne un support d'inter connexion des boîtiers de circuit intégré du type connu sous l'appellation anglo-saxonne »chip-carrier« sur un circuit imprimé, ledit support étant coustitué d'un diélectrique souple formé d'une couronne percée d'une ouverture centrale munie sur l'une de ses faces d'une première série de contacts électriques, chaque contact s'étendant sensiblement jusqu'au bord de l'ouverture centrale. Un tel type de support est connu de FR-A-23 32 620.

Les puces constituant les circuits intégrés à grande échelle sont généralement mises dans des boîtiers comportant une embase en céramique revêtue de contacts électriques sérigraphiés auxquels les contacts de sortie de la puce sont reliés généralement par thermo-compression. Ces boîtiers de circuit intégré sont généralement appelés dans la terminologie anglo-saxonne »chip-carrier«, terme qui sera utilisé dans toute la suite de la présente description.

La céramique constituant ces chip-carriers possède un très faible coefficient de dilatation thermique et plus généralement une très bonne tenue en température qui justifie son utilisation dans ce type d'application. Ces chip-carriers sont destinés à l'implantation sur des cartes de circuits imprimés multi-couches faisant euxmêmes partis d'appareils électroniques. Actuellement, l'interconnexion entre le chip-carrier et le circuit imprimé se fait soit par l'intermédiaire de connecteurs, soit par l'intermédiaire d'embases particulièrement adaptées. Ces »chip-carriers« ne peuvent être brasés directement sur les circuits imprimés car ceux-ci possèdent un coefficient de dilatation thermique nettement plus élevé que celui de la céramique, ce qui provoque au cours des cycles thermiques subis par la carte imprimée, un arrachement au niveau des contacts d'interconnexion du chip-carrier et du circuit imprimé. Il n'existe donc pas à l'heure actuelle de moyens simples et économiques permettant de relier un chip-carrier à un circuit imprimé sans risque d'arrachement au niveau des joints de brasure d'interconnexion entre les deux.

Le support d'interconnexion selon l'invention permet de résoudre simplement le problème posé. Dans ce but, il est caractérisé en que la couronne est munie sur l'autre de ses faces d'une deuxième série de contacts, chacun d'entre eux étant relié à l'un des contacts de la première série, et disposé sensiblement à la périphérie de la couronne de manière à laisser une surface libre entre chaque contact de la deuxième série et le bord de l'ouverture. En brasant respectivement le chip-carrier sur la première série de contacts et le circuit imprimé sur la deuxième série de contacts, on laisse ainsi un espace libre sous le chip-carrier, cet espace permettant au support d'interconnexion selon l'invention d'absorber les contraintes thermo-mécaniques engendrées par les différences de dilatation thermique entre le chip-carrier et le circuit imprimé et éviter ainsi l'arrachement des connexions électriques.

Afin d'améliorer encore les résultats obtenus avec ce support d'interconnexion, celui-ci comportera de préférence une pluralité de fentes s'étendant de l'ouverture centrale sensiblement jusqu'à la deuxième série de contacts.

L'invention concerne également un système d'interconnexion d'un chip-carrier sur un circuit imprimé utilisant un support tel que décrit dans le préambule de la revendication 5. Ce système est caractérisé en ce que la couronne est munie sur l'autre de ses faces d'une deuxième série de contacts électriques, chacun d'entre eux étant disposé sensiblement à la périphérie de la couronne, relié à l'un des contacts de la première série et relié à l'un des contacts correspondant du circuit imprimé, la distance, dans une section perpendiculaire à l'ensemble du système, entre les bords de l'ouverture ($d_1$) étant inférieure à celle entre les contacts opposés de la deuxième série ($d_4$) de manière à ménager un espace libre de largeur ($d_5$) entre le diélectrique souple (7) et le circuit imprimé (38) permettant ainsi d'absorber sans endommagement des contacts (2, 33, 35, 44) les dilatations thermiques différentes du boîtier (36) et du circuit imprimé (38). Un tel système d'interconnexion permet en particulier d'augmenter considérablement la densité des chip-carriers sur le circuit imprimé. En effet, le circuit imprimé est un circuit tout à fait habituel, et peut posséder des trous métallisés d'interconnexion entre les différentes couches disposées sous le chip-carrier. De cette manière, on peut ainsi mettre côte à côte plusieurs chip-carriers sans être obligé de les séparer par des rangées de trous métallisés d'interconnexion.

Par ailleurs, le système d'interconnexion selon l'invention est également remarquable en ce que le support d'interconnexion comporte des moyens de positionnement qui coopèrent avec des moyens de positionnement complémentaires disposés sur le circuit, permettant le brasure simultanée du boîtier sur le support et du support sur le circuit.

L'invention sera mieux comprise à l'aide des exemples de réalisation suivants, donnés à titre non limitatif, conjointement avec les figures qui représentent:

— la figure 1, une vue de dessous du support d'interconnexion selon l'invention,

— la figure 2, une vue de dessous du support d'interconnexion selon l'invention,

— la figure 3, une vue d'un système d'interconnexion selon l'invention,

— la figure 4, une variante de réalisation de la figure 3.

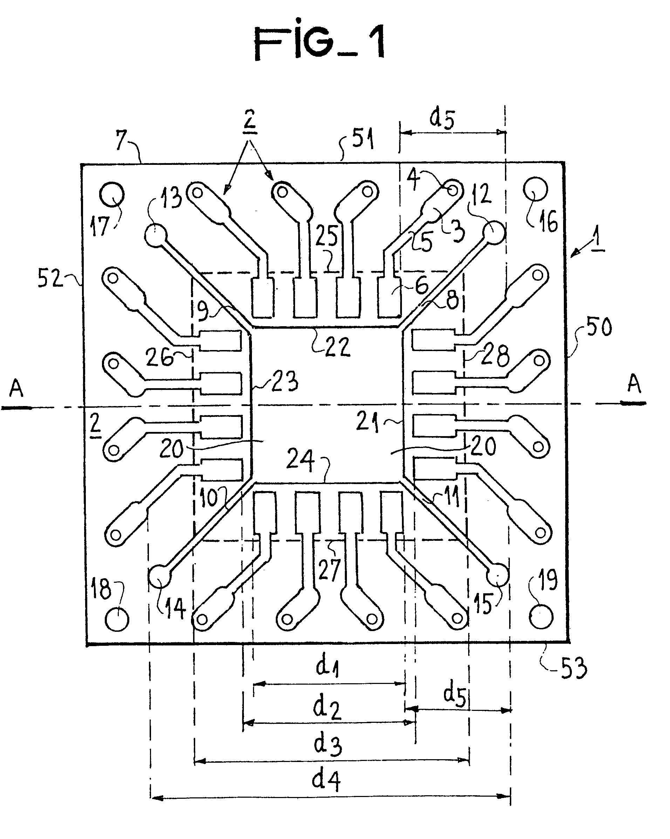

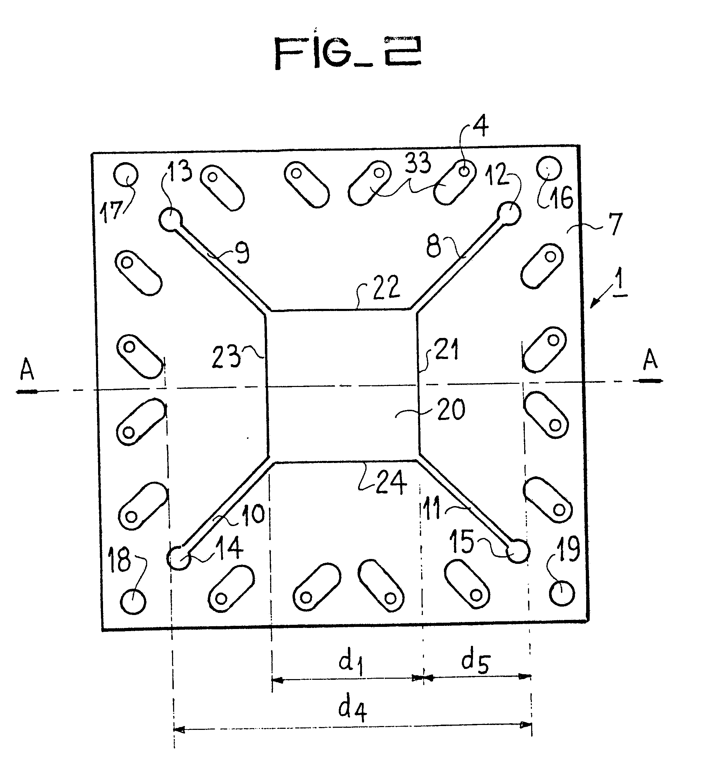

Sur la figure 1, est représenté un support d'interconnexion (1) selon l'invention. Ce support d'interconnexion a ici la forme d'un carré de côtés 50, 51, 52 et 53. Il est constitué par un diélectrique souple 7 qui possède une ouverture centrale 20 ayant elle-même la forme d'un carré de côtés 21, 22, 23 et 24. Des fentes 8, 9, 10 et 11 disposées sensiblement le long des diagonales de ce carré s'étendent depuis l'ouverture centrale 20 jusqu'à proximité de l'extrémité des contacts électriques 2. Ces fentes se terminent respectivement par des parties circulaires 12, 13, 14 et 15 évitant au support 1 de se déchir en cas de déformation. Le support 1 est revêtu sur sa face supérieure représentée sur la figure 1 d'une pluralité de contacts électriques 2, ces contacts étant dans le cas de la présente figure au nombre de 16, c'est-à-dire quatre contacts le long de chaque bord de l'ouverture 20. Ces contacts électriques 2 comportent une partie 6 disposée à proximité du bord correspondant de l'ouverture 20, prolongée par une partie de plus faible largeur 5, se terminant par une partie plus large 3, sensiblement de même largeur que celle de la partie 6. Cette partie 3 est disposée non loin du bord correspondant 51 du support 1. Elle comporte une partie 4 représentant un trou métallisé pour l'interconnexion de ce contact électriques 2 avec un contact électriques correspondant 33 (figure 2). Aux quatre coins du support, sont disposés quatre trous de centrage 16, 17, 18, 19 permettant de positionner correctement le support sur le circuit imprimé avant l'opération de brasure. On a également représenté en pointillés sur cette figure le contour extérieur du chip-carrier, matérialisé par ses côtés 25, 26, 27 et 28. La largeur de l'ouverture carrée 20 est égale à $d_1$, la distance entre deux contacts 2 en vis-à-vis l'un de l'autre est égale à $d_2$, la dimension extérieure du chip-carrier est égale à $d_3$, tandis que la distance entre les parties arrières 3 des contacts 2, entre deux contacts en vis-à-vis, est égale à $d_4$. La distance séparant le bord de l'ouverture 20 et l'extrémité d'une rangée de contacts d'extrémité 3 est égale à $d_5$.

Sur la figure 2, est représenté le verso du support illustré sur la figure 1, les mêmes éléments portant les mêmes références. Une pluralité de contacts 33 formant une deuxième série de contacts électriques, est disposée sensiblement à la périphérie du support 1. Chacun de ces contacts 33 est relié via le trou métallisé 4 à l'un des contacts 2 de la face supérieure. L'ensemble des trous métallisés 4 est sensiblement aligné avec les trous de positionnement tels que 16 et 17 disposés sur les bords du support 1. Ainsi qu'on peut le remarquer sur la figure 2, le verso du support 1 comporte donc une partie de largeur $d_5$ entre l'extrémité des contacts tels que 33 et le bord correspondant de l'ouverture 20 est une zone sans contact électrique dans laquelle le diélectrique du support est mis à nu.

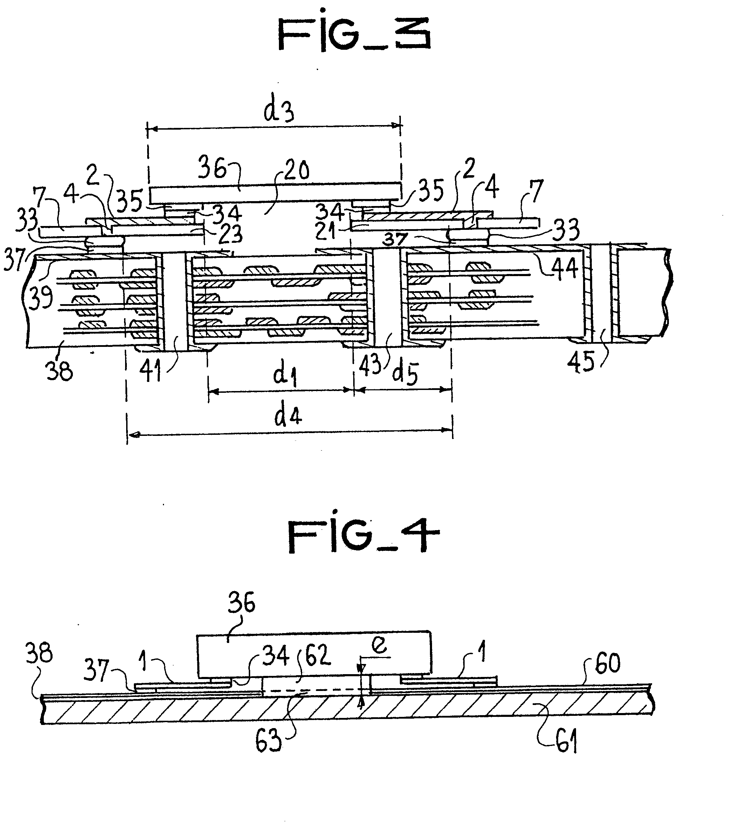

La figure 3 permet de mieux comprendre l'utilisation du support d'interconnexion selon l'invention telle que représentée sur les figures 1 et 2. Sur cette figure 3, les mêmes éléments que ceux des figures précédentes portent les mêmes références. Cette figure 3 représente une vue en coupe d'un chip-carrier 36 interconnecté à l'aide du support 1 à un circuit imprimé multi-couches 38, cette vue en coupe étant effectuée le long de l'axe AA des figures précédentes. Les contacts extérieurs 35, par exemple sérigraphiés, du chip-carrier 36 sont reliés par l'intermédiaire des plots de brasures 34 aux contacts électriques 2. Ceux-ci sont reliés par l'intermédiaire du trou métallisé 4 aux contacts électriques 33 situés au verso du support diélectrique 7. Ces contacts métallisés 33 sont eux-mêmes reliés par l'intermédiaire des plots de brasures aux contacts électriques tels que 39 et 44 du circuit imprimé multi-couches 38. Celui-ci possède une pluralité de couches conductrices, représentées par des traits hachurés sur la figure, séparées par des couches diélectriques isolantes, lesdites couches conductrices étant reliées entre elles par l'intermédiaire de trous métallisés tels que 41, 43 et 45. L'interconnexion du chip-carrier 36 sur le circuit imprimé multicouches 38 s'effectuant après la réalisation dudit circuit imprimé multi-couches 38, celui-ci peut donc comporter des trous métallisés d'interconnexion tels que 41 et 43 situés sous ledit chip-carrier 36, c'est-à-dire à l'intérieur de la surface délimitée par les contacts électriques tels que 33. Ceci permet en particulier d'augmenter considérablement la densité des circuits du type chip-carrier sur les circuits imprimés puisque les interconnexions entre les contacts tels que 35 et les différentes couches métalliques du circuit imprimé multi-couches s'effectuent à l'intérieur de cette surface délimitée par la distance $d_4$. Il est donc possible de juxtaposer ces systèmes sans laisser d'espace entre deux chip-carriers consécutifs. Une telle solution ne serait pas possible si le support d'interconnexion tel que représenté sur la figure avait été réalisé directement sur le circuit imprimé après réalisation de celui-ci (voir FR-A-2 486 755). En effet, dans l'exemple décrit dans ce brevet, la présence de trous métallisés entre les contacts tels que 33 n'est pas possible compte tenu du fait que le contact électrique serait alors supprimé au cours de la réalisation du circuit.

Le fonctionnement du système d'interconnexion selon l'invention est aisé à comprendre d'après la figure 3. Le support d'interconnexion 1 est positionné sur le circuit imprimé multi-couches 38, par exemple en enfilant le support d'interconnexion 1 sur des ergots (au moins deux) préalablement positionnés sur le circuit imprimé 38, à l'aide des trous de positionnement 16, 17, 18, 19 qui permettent de disposer exactement les contacts 33 au-dessus des contacts correspondants du circuit imprimé 38. (Il est à noter que le positionnement relatif du support d'interconnexion et du circuit imprimé peut également être réalisé en effectuant des protubérances ou déformations, de forme quelconque dans le support d'interconnexion luimême. Ces protubérances peuvent résulter par exemple, d'une déformation à chaud du support d'interconnexion ou d'un perçage avec déformation sur un côté du trou). Par ailleurs, le chip-carrier 36 est disposé sur le dessus du support d'interconnexion 1.

L'ensemble des contacts électriques est alors brasé par exemple en phase vapeur en amenant la température de l'ensemble du système à la température de fusion de la brasure préalablement disposée aux endroits adéquats (34 et 37). C'est un avantage particulièrement important de l'invention que de permettre d'utiliser la même nature de brasure aux endroits 34 et 37, puisque la brasure du chip-carrier sur le support d'interconnexion 1 et la brasure de ce dernier sur le circuit imprimé 38 peuvent être réalisées simultanément, donc à la même température.

Il est aisé de comprendre que le support 7 n'étant pas solidaire du circuit imprimé 38, un espace 20 existe entre le chip-carrier 36 et le circuit imprimé 38, ledit espace permettant la dilatation dans une large plage de température du circuit imprimé sans risque d'arrachement des brasures, notamment aux points 34 et 37.

A titre non limitatif, et pour un chip-carrier de dimension $d_3$ égale à 7,62 mm, on a réalisé un support 1 en film polyimide de 50 microns d'épaisseur recouvert de contacts électriques 2 en cuivre, dans lequel une ouverture centrale 20 de largeur $d_1$ égale à 4,5 mm avait été réalisée. Les dimensions extérieures du support 1 étaient celles d'un carré de 14,5 mm de côté. Les fentes diagonales telles que 8 avaient une longueur de l'ordre de 4 mm et se terminaient par une partie circulaire de 0,8 millimètre de diamètre. La distance $d_4$ entre les contacts 33 de la face inférieure était de l'ordre de 11 mm, laissant ainsi une distance $d_5$ libre de contacts électriques d'une largeur de l'ordre de 3 mm. Après avoir brasé simultanément en phase vapeur un chip-carrier, un support d'interconnexion selon l'invention et une carte de circuit imprimé, on a fait subir à l'ensemble 500 cycles thermiques. Au cours de chacun d'eux, l'ensemble est porté pendant 30 mn à −55°C puis pendant 30 mn à +125°C. Le passage de −55°C à +125°C et vice-versa (transfert d'une étuve à l'autre) doit se faire en moins de 2 mn. Après 500 cycles, on n'a constaté aucune dégradation des différentes interconnexions.

Il est à noter par ailleurs qu'afin d'améliorer encore les possibilités de tenue en température du dispositif 1, on peut, par exemple, réaliser les contacts tels que 2 avec une partie 5 en forme de V, c'est-à-dire possédant deux branches faisant entre elles un angle supérieur ou égal à environ 120°.

Sur la figure 4, est représentée une variante de réalisation de la figure 3, plus spécialement applicable dans le cas où le problème thermique est important. Sur cette figure, les mêmes éléments que ceux des figures précédentes portent les mêmes références. La carte imprimée 38 utilisée ici est constituée d'un drain thermique 61 revêtu d'un circuit imprimé mince 60 dans lequel on a pratiqué une ouverture 63 sous le »chip-carrier« 36. Cette ouverture 63 a une largeur inférieure ou égale à la largeur $d_1$ du support d'interconnexion 1. Une pâte thermiquement conductrice 62 est introduite dans cette ouverture 63 jusque sous le chip-carrier 36, sur une épaisseur e. Cette pâte peut être par exemple une pâte de silicones polymérisés, chargés de particules thermiquement conductrices. Ce joint thermique coopère avec le support de l'invention et améliore encore les performances du système d'interconnexion de l'invention. Cette solution est particulièrement intéressante lorsque la résistance thermique de ce joint est la plus faible possible, c'est-à-dire l'épaisseur e la plus faible possible. En pratique, on a constaté qu'une épaisseur e de l'ordre de 0,5 mm donnait entièrement satisfaction.

Il est à noter que l'idée mère de l'invention est basée sur le fait que les brasures 34 et 37 sont séparées d'une distance de l'ordre de $d_5$ (voir figure 3). Il est bien entendu que les contacts électriques tels que 2 peuvent ne pas s'étendre jusqu'à l'ouverture 20, que celleci peut être de dimension beaucoup plus petite que la distance entre deux contacts 2 en vis-à-vis, que les contacts tels que 33 peuvent s'étendre également jusqu'à proximité de l'ouverture 20, etc. . . . ., ces variantes faisant partie de l'invention.

**Revendications**

1. Support d'interconnexion d'un boîter (36) de circuit intégré sur un circuit imprimé (38), ledit support (1) étant constitué d'un diélectrique souple (7) formé d'une couronne percée d'une ouverture centrale (20) et munie sur l'une de ses faces d'une première série de contacts électriques (2), chaque contact s'étendant sensiblement jusqu'au bord de l'ouverture centrale caractérisé en ce que ladite couronne est munie sur l'autre de ses faces d'une deuxième série de contacts électriques (33), chacun d'entre eux étant relié à l'un des contacts (2) de première série, et disposé sensiblement à la périphérie de la couronne, de manière à laisser un espace libre ($d_5$) entre chaque contact (33) de la deuxième série et le bord de l'ouverture centrale (20).

2. Support d'interconnexion selon la revendication 1, caractérisé en ce qu'il comporte une pluralité de fentes (8, 9, 10, 11) s'étendant de l'ouverture centrale (20) sensiblement jusqu'à la deuxième série de contacts (33).

3. Support d'interconnexion selon l'une des revendications 1 ou 2, caractérisé en ce que le support (1) est rectangulaire et comporte quatre fentes (8, 9, 10, 11) disposées le long des diagonales.

4. Support d'interconnexion selon l'une des revendications 1 à 3, caractérisé en ce que le support (1) est un diélectrique souple, chaque fente (8, 9, 10, 11) se terminant par une partie arrondie (12, 13, 14, 15), plus large que la fente, évitant les déchirures du support.

5. Système d'interconnexion utilisant un support d'interconnexion d'un boîtier (36) de circuit intégré sur un circuit imprimé (38), ledit support étant constitué d'un diélectrique souple (7) formé d'une couronne percée d'une ouverture centrale (20) et munie sur l'une de ses faces d'une première série de contacts électriques, chaque contact s'étendant sensiblement jusqu'au bord de l'ouverture centrale et chaque contact étant relié à un contact de sortie (35) du boîtier du circuit intégré caractérisé en ce que ladite couronne est munie sur l'autre de ses faces d'une deuxième série de contacts électriques, chacun d'entre eux étant disposé sensiblement à la périphérie de la couronne, relié à l'un des contacts de la première série et relié à un contact correspondant (39, 44) du circuit imprimé, la distance ($d_1$), dans une section perpendiculaire à l'ensemble du système, entre les bords de l'ouverture (20) étant inférieure à celle ($d_4$) entre les contacts opposés (33) de la deuxième série, de manière à ménager un espace libre ($d_5$) entre le diélectrique souple (7) et le circuit imprimé (38) permettant d'absorber sans endommagements des contacts (2, 33, 35, 44) les dilatations thermiques différentes du boîtier (36) et du circuit imprimé (38).

6. Support d'interconnexion selon la revendication 5, caractérisé en ce que ledit support comporte une pluralité de fentes (8, 9, 10, 11) s'étendant de l'ouverture centrale (20) sensiblement jusqu'à la deuxième série de contacts (33).

7. Système d'interconnexion selon la revendication 5, caractérisé en ce que le circuit imprimé (38) comporte des trous métallisés d'interconnexion (41, 43) disposés à l'intérieur de la zone délimitée par les contacts (33) des la deuxième série, le diélectrique souple (7) isolant, séparant dans tous les cas les trous métallisés de l'embase du circuit intégré.

8. Système d'interconnexion selon l'une des revendications 5 ou 6, caractérisé en ce que le circuit (38) comporte un circuit imprimé mince (60) assemblé avec un drain thermique (61), le circuit imprimé mince (60) comportant une ouverture (63) disposée sous le boîtier (36), l'espace situé entre la partie inférieure du boîtier (39) et le drain thermique (61) étant rempli de pâte thermiquement conductrice (62) au niveau de l'ouverture (63).

9. Système d'interconnexion selon l'une des revendications 5 à 7, caractérisé en ce que le support d'interconnexion (1) comporte des moyens de positionnement qui coopèrent avec des moyens de positionnement complémentaires disposés sur le circuit (38), permettant la brasure simultanée du boîtier sur le support (1) et du support (1) sur le circuit (38).

**Patentansprüche**

1. Verbindungsträger für ein Gehäuse (36) eines integrierten Schaltkreises auf einer Druckschaltung (38), wobei der Träger (1) aus einem biegsamen Dielektrikum (7) in Form einer Krone besteht, das eine zentrale Öffnung (20) und auf einer seiner Seiten eine erste Serie von elektrischen Kontakten (2) aufweist, wobei jeder Kontakt sich im wesentlichen bis zum Rand der zentralen Öffnung erstreckt, dadurch gekennzeichnet, daß die Krone auf ihrer anderen Seite eine zweite Serie von elektrischen Kontakten (33) aufweist, die je mit einem der Kontakte (2) der ersten Serie verbunden sind und im wesentlichen an der Peripherie der Krone liegen, so daß ein Freiraum ($d_5$) zwischen jedem Kontakt (33) der zweiten Serie und dem Rand der zentralen Öffnung (20) verbleibt.

2. Verbindungsträger nach Anspruch 1, dadurch gekennzeichnet, daß er mehrere Schlitze (8, 9, 10, 11) aufweist, die sich von der zentralen Öffnung (20) im wesentlichen bis zur zweiten Serie von Kontakten (33) erstrecken.

3. Verbindungsträger nach einem der Ansprüche 1 oder 2, dadurch gekennzeichnet, daß der Träger (1) Rchteckform besitzt und vier Schlitze (8, 9, 10, 11) aufweist, die entlang der Diagonalen verlaufen.

4. Verbindungsträger nach einem der Ansprüche 1 bis 3, dadurch gekennzeichnet, daß der Träger (1) aus einem biegsamen Dielektrikum besteht, wobei jeder Schlitz (8, 9, 10, 11) in einem abgerundeten Bereich (12, 13, 14, 15), der weiter als der Schlitz ist, endet, so daß der Träger nicht einreißen kann.

5. Verbindungssystem unter Verwendung eines Verbindungsträgers für ein Gehäuse (36) eines integrierten Schaltkreises auf einer Druckschaltung (38), wobei der Träger aus einem biegsamen Dielektrikum in Form einer Krone (7) besteht, das eine zentrale Öffnung (20) und auf einer seiner Seiten eine erste Serie von elektrischen Kontakten aufweist, wobei jeder Kontakt sich im wesentlichen bis zum Rand der zentralen Öffnung erstreckt und an einen Ausgangskontakt (35) des Gehäuses des integrierten Schaltkreises angeschlossen ist, dadurch gekennzeichnet, daß die Krone auf ihrer anderen Seite eine zweite Serie von elektrischen Kontakten aufweist, die im wesentlichen an der Peripherie der Krone liegen und je an einen der Kontakte der ersten Serie und einen entsprechenden Kontakt (39, 44) des integrierten Schaltkreises angeschlossen sind, wobei der Abstand ($d_1$) zwischen den Rändern der Öffnung (20) in einem Querschnitt senkrecht zur Gesamtheit des Systems geringer als der Abstand ($d_4$) zwischen den entgegengesetzten Kontakten (33) der zweiten Serie gewählt ist, so daß sich ein Freiraum ($d_5$) zwischen dem biegsamen Dielektrikum (7) und dem integrierten Schaltkreis (38) ergibt, der eine Absorption der unterschiedlichen thermischen Ausdehnungen des Gehäuses (36) und des integrierten Schaltkreises (38) ohne Beschädigung der Kontakte (2, 33, 35, 44) erlaubt.

6. Verbindungsträger nach Anspruch 5, dadurch gekennzeichnet, daß dieser Träger mehrere Schlitze (8, 9, 10, 11) aufweist, die sich von der zentralen Öffnung (20) im wesentlichen bis zur zweiten Serie von Kontakten (33) erstreckt.

7. Verbindungssystem nach Anspruch 5, dadurch gekennzeichnet, daß der integrierte Schaltkreis (38) metallisierte Verbindungslöcher (41, 43) innerhalb der von den Kontakten (33) der zweiten Serie begrenzten Zone aufweist, wobei das isolierende und biegsame Dielektrikum (7) in allen Fällen die metallisierten Löcher von der Basis des integrierten Schaltkreises trennt.

8. Verbindungssystem nach einem der Ansprüche 5 oder 6, dadurch gekennzeichnet, daß der Schaltkreis (38) einen Dünnschicht-Schaltkreis (60) enthält, der mit einer thermischen Drain-Elektrode (61) zusammengebaut ist, wobei der integrierte Dünnschicht-Schaltkreis (60) eine Öffnung (63) aufweist, die unter dem Gehäuse (36) angeordnet ist, und der Raum zwischen dem Unterteil des Gehäuses (36) und der thermischen Drain-Elektrode (61) mit einer thermisch leitenden Paste (62) in Höhe der Öffnung (63) gefüllt ist.

9. Verbindungssystem nach einem der Ansprüche 5 bis 7, dadurch gekennzeichnet, daß der Verbindungsträger (1) Ausrichtmittel aufweist, die mit komplementären Ausrichtmitteln auf der Druckschaltung (38) zusammenwirken und eine gleichzeitige Verlötung des Gehäuses mit dem Träger (1) und des Trägers (1) mit dem Schaltkreis (38) ermöglichen.

**Claims**

1. An interconnection support for an integrated circuit housing (36) on a printed circuit (38), wherein the support (1) is constituted by a flexible dielectric material (7) formed from a crown having a central opening (20) and provided on one of its faces with a first series of electrical contacts (2), each contact extending substantially up to the edge of the central opening, characterized in that said crown is provided on the other of its faces with a second series of electrical contacts (33), each of them being connected to one of the contacts (2) of the first series, and disposed substantially at the periphery of the crown, so as to leave a free space ($d_5$) between each contact (33) of the second series and the edge of the central opening (20).

2. An interconnection support according to claim 1, characterized in that it has a plurality of slots (8, 9, 10, 11) extending from the central opening (20) substantially up to the second series of contacts (33).

3. An interconnection support according to one of claims 1 or 2, characterized in that the support (1) is rectangular and has four slots (8, 9, 10, 11) disposed along the diagonals.

4. An interconnection support according to one of claims 1 to 3, characterized in that the support (1) is a flexible dielectric material, each slot (8, 9, 10, 11) being terminated by a rounded portion which is wider than the slot and prevents tearing of the support.

5. An interconnection system using an interconnection support for an integrated circuit housing (36) on a printed circuit (38), wherein the support is constituted by a flexible dielectric material (7) formed from a crown having a central opening (20) and provided on one of its faces with a first series of electrical contacts, each contact extending substantially up to the edge of the central opening and being connected to an output contact (35) of the integrated circuit housing, characterized in that said crown is provided on its other face with a second series of electrical contacts, each contact of said second series being disposed substantially at the periphery of the crown, being connected to one of the contacts belonging to the first series and being connected to a corresponding contact (39, 44) of the printed circuit, the distance ($d_1$) in a section perpendicular to the complete system, between the edges of the opening (20) is less than the distance ($d_4$) between the opposite contacts (33) of the second series, so as to provide a free space ($d_5$) between the flexible dielectric material (7) and the printed circuit (38) thereby making it possible to absorb the differential thermal expansions of the housing (36) and the printed circuit (38) without damaging the contacts (2, 33, 35, 44).

6. An interconnection support according to claim 5, characterized in that said support comprises a plurality of slots (8, 9, 10, 11) which extend from the central opening (20) substantially up to the second series of contacts (33).

7. An interconnection system according to claim 5, characterized in that the printed circuit (38) has metallized interconnection holes (41, 43) arranged inside the area defined by the contacts (33) of the second series, the flexible insulating dielectric material (7) in all cases separating the metallized holes from the base of the integrated circuit.

8. An interconnection system according to one of claims 5 or 6, characterized in that the circuit (38) incorporates a thin printed circuit (60) assembled with a heat drain (61), the thin printed circuit (60) having an opening (63) located beneath the housing (36), the space between the lower part of the housing (36) and the thermal drain (61) being filled with a thermally conductive paste (62) at the said opening (63).

9. An interconnection system according to one of claims 5 to 7, characterized in that the interconnection support (1) has positioning means, which cooperate with complementary positioning means disposed on the circuit (38), permitting the simultaneous soldering of the housing to the support (1) and of the support (1) to the circuit (38).

# FIG_1

FIG_2

# FIG_3

# FIG_4